# EUROPEAN PATENT APPLICATION

(11) **EP 2 398 011 A2**
(43) Date of publication of application: **21.12.2011**
(21) Application number: 10741337.9
(22) Date of filing: 06.01.2010
(51) Int. Cl.: G09G 3/30, H01L 51/50, H01L 51/54

(54) **PIXEL CIRCUIT OF OLED PANEL, DISPLAY DEVICE USING THE SAME AND METHOD FOR DRIVING THE OLED PANEL**

(30) Priority: 16.02.2009 KR 20090012557; 29.05.2009 KR 20090047782
(71) Applicant: Neoviewkolon Co., Ltd., Chungcheongnam-Do 350-883 (KR)
(72) Inventor: CHOI, Dong-Wook, Hwaseong-si Gyeonggi-do 445-802 (KR)
(74) Representative: Beck & Rössig European Patent Attorneys
(86) International application number: PCT/KR2010/000049
(87) International publication number: WO 2010/093119

(57) **Abstract**

Disclosed herein is a pixel circuit for an OLED panel, a display device having the pixel circuit and a method of driving the OLED panel. The pixel circuit for an OLED panel includes a switching element driven by a scan signal input through a corresponding one of scan lines sequentially selected from among a plurality of scan lines, and configured to transfer drive current based on luminance data input through a corresponding one of a plurality of data lines. An OLED emits light using the drive current transferred by the switching element. The OLED has an anode connected to a source terminal of the transistor and a cathode connected to a common electrode. Accordingly, problems such as the imbalance and deterioration of luminance attributable to the sequential driving of scan lines can be solved, and the complexity of circuits of a conventional AMOLED panel can be solved.

## Description

### BACKGROUND OF THE INVENTION

### 1. Field of the Invention

The present invention relates, in general, to Organic Light Emitting Diode (OLED) panels, and, more particularly, to a pixel circuit for an OLED panel which has a simple structure and is not influenced by the reliability characteristics of transistors used as driving elements, and to a display device having the pixel circuit and a method of driving the OLED panel using the pixel circuit.

### 2. Description of the Related Art

Generally, Organic Light Emitting Diode (OLED) panels are classified into Passive Matrix OLED (PMOLED) panels and Active Matrix OLED (AMOLED) panels. OLED panels may also be manufactured as transparent OLED panels.

PMOLED panels have relatively simple structures because of their characteristics.

However, PMOLED panels, especially, transparent PMOLED panels, are problematic in that there are limitations in manufacturing them in a dot matrix form due to the high resistance of transparent cathodes and the deterioration of the transparency of a partition material. Accordingly, such PMOLED panels are mainly used only for small-sized panels suitable for the formation of icons at the most, and have many restrictions placed on the display of text or graphic images.

Meanwhile, in the case of AMOLED panels, the problems of PMOLED panels, that is, the imbalance and deterioration of luminance which occurs when individual pixels are sequentially driven depending on scan lines, can be solved. Further, such an AMOLED panel is advantageous in that it can be manufactured as a dot matrix panel having a relatively large size, unlike a PMOLED panel. However, such an AMOLED panel is problematic because it is driven by adjusting the amount of current of transistors used as driving elements, so that high reliability of the transistors is required. Further, AMOLED panels are problematic because the imbalance of luminance occurs due to variations in the characteristics of transistors which are driving elements. In order to solve this problem, a component such as a compensation circuit or a capacitor is additionally required, and thus the structure of an AMOLED panel is relatively complicated. Due thereto, there is a problem in that the cost of manufacturing an AMOLED panel increases.

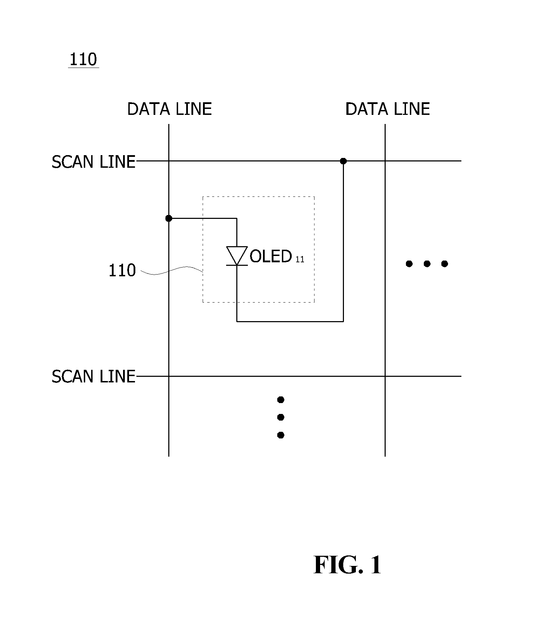

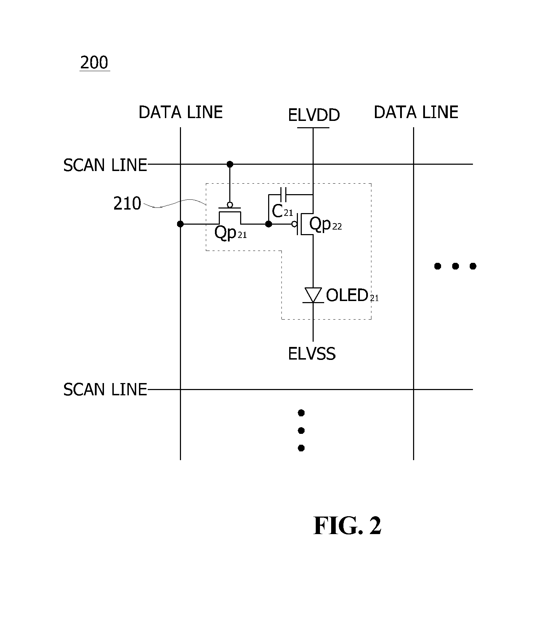

Hereinafter, the problems of pixel circuits used for PMOLED panels and AMOLED panels will be described in detail with reference to FIGS. 1 and 2.

FIG. 1 is a circuit diagram showing a pixel circuit for a conventional PMOLED panel.

Referring to FIG. 1, a PMOLED panel 100 includes a plurality of pixel circuits 110 implemented in a dot matrix form. In FIG. 1, only one pixel circuit 10 is exemplarily shown.

Each pixel circuit 110 can be conceptually and simply represented to be implemented using a single organic light emitting diode OLED₁₁. The terminals of OLED₁₁ are respectively connected to a scan line and a data line.

Data lines are connected to a data driving circuit (not shown), and scan lines are connected to a scan line driving circuit (not shown).

The data driving circuit can divide luminance into various levels, and provide data about the luminance, divided into the levels, to the individual pixel circuits 110. Further, the scan line driving circuit sequentially drives individual scan lines according to a scan driving method.

In this case, as the luminance data is provided to the data lines and the scan lines are sequentially driven, current flows through each OLED₁₁, and then each OLED₁₁ emits light.

However, when the scan lines are connected to the pixel circuits 110 according to the sequential driving method, the imbalance of luminance occurs due to the differences between the resistances of the scan lines. Further, the deterioration of luminance occurs due to the high resistance of the scan lines and the data lines, and thus the conventional PMOLED panel 100 exhibits technical limitations in the sizes of the panels to be manufactured.

FIG. 2 is a circuit diagram showing a pixel circuit for a conventional AMOLED panel.

Referring to FIG. 2, an AMOLED panel 200 includes a plurality of pixel circuits 210 implemented in a dot matrix form. In FIG. 2, only one pixel circuit 210 is exemplarily shown, similarly to FIG. 1.

In each pixel circuit 210, a transistor QP₂₁ connected between a data line and a scan line functions to perform switching. Predetermined luminance data is provided to the pixel circuits 210 through data lines, and 'low' signals are sequentially applied to the pixel circuits 210 through individual scan lines, so that individual transistors QP₂₁ are turned on.

Then, a data voltage is input to the gate terminal of a transistor QP₂₂, so that a fixed voltage is formed at a capacitor C₂₁. The transistor QP₂₂ determines current to be supplied to OLED₂₁ on the basis of the data voltage input to the gate terminal and the threshold voltage of the transistor QP₂₂.

In this case, it can be seen that even though a 'high' signal is driven on the scan line and the transistor QP₂₁ is turned off, the voltage provided through the data line still remains in the capacitor C₂₁ without change.

That is, it can be seen that the AMOLED panel 200 solves the problem of the imbalance of luminance which occurred in the PMOLED panel 100 due to the sequential driving of the scan lines.

However, the transistor QP₂₂ of the AMOLED panel 200 is disadvantageous in that variations in the characteristics thereof are serious depending on manufacturing processes. Therefore, the dot matrix AMOLED panel 200 causes the imbalance of luminance depending on the variations in the characteristics of transistors QP₂₂ in respective unit pixels.

At the present time, in order to solve the problem of the imbalance of luminance occurring in the above-described AMOLED panel, a compensation circuit technique of adding a plurality of transistors and capacitors to each pixel is used. However, an AMOLED panel 200 using the compensation circuit technique has many difficulties in manufacture because the manufacturing process thereof is complicated and troublesome.

Furthermore, the AMOLED panel 200 is subject to high voltage and current stresses because each transistor QP₂₂ directly controls current to be supplied to OLED₂₁. Accordingly, in order to manufacture a high-quality AMOLED panel 200, the problem of guaranteeing high reliability of transistors QP₂₂ still remains.

### SUMMARY OF THE INVENTION

Accordingly, the present invention has been made keeping in mind the above problems occurring in the prior art, and an object of the present invention is to provide a pixel circuit for an OLED panel, which does not cause the problem of the imbalance of luminance while simplifying the structure of the OLED panel compared to an AMOLED panel.

Another object ofthe present invention is to provide a display device having the pixel circuit.

A further object of the present invention is to provide a method of driving the OLED panel using the pixel circuit.

In accordance with an aspect of the present invention to accomplish the objects, there is provided a pixel circuit for an Organic Light Emitting Diode (OLED) panel, comprising a switching element driven by a scan signal input through a corresponding one of scan lines sequentially selected from among a plurality of scan lines, and configured to transfer drive current based on luminance data input through a corresponding one of a plurality of data lines, and an OLED configured to emit light using the drive current transferred by the switching element.

Preferably, the switching element may comprise a transistor, a gate terminal of which is connected to the corresponding scan line, a drain terminal of which is connected to the corresponding data line, and a source terminal of which is connected to the OLED.

Preferably, the OLED may have an anode connected to the source terminal of the transistor and a cathode connected to a common electrode.

Preferably, the transistor may be an N-type or P-type metal oxide thin film transistor.

Preferably, the metal oxide thin film transistor may comprise an active layer made of any one selected from a group consisting of Zinc Oxide (ZnO), Indium Zinc Oxide (IZnO) and Indium Gallium Zinc Oxide (IGZO).

Preferably, the OLED may comprise a transparent OLED (TOLED).

Preferably, the OLED may comprise a substrate, a first electrode formed on the substrate, an organic layer formed on the first electrode, a second electrode formed on the organic layer, and a transparent layer formed between the organic layer and the second electrode and/or on the second electrode, and configured to include any one selected from a group consisting of oxides, nitrides, salts and mixtures thereof.

Preferably, the oxides may comprise any one selected from a group consisting of MoO₃, ITO, IZO, IO, ZnO, TO, TiO₂, SiO₂, WO₃, Al₂O₃, Cr₂O₃, TeO₂, and SrO₂.

Preferably, the nitrides may comprise any one selected from a group consisting of SiN and AIN.

Preferably, the salts may comprise any one selected from a group consisting of Cs₂CO₃, LiCO₃, KCO₃, NaCO₃, LiF, CsF and ZnSe.

Preferably, the transparent layer may be formed to have a thickness which is equal to or greater than 0.1 nm and less than 100 nm.

Preferably, the organic layer may comprise an electron transporting layer doped with any one selected from a group consisting of low-work-function metals and mixtures thereof to facilitate injection of electrons from the second electrode.

Preferably, the low-work-function metals may comprise any one selected from a group consisting of Cs, Li, Na, K and Ca.

Preferably, the mixtures of the low-work-function metals may comprise any one selected from a group consisting of Li-Al, LiF, CsF and Cs₂CO₃.

Preferably, the OLED may exhibit a transmittance ranging from 70 to 99% depending on wavelength (nm).

In accordance with another aspect of the present invention to accomplish the objects, there is provided a display device, comprising a scan line driving circuit for sequentially outputting scan signals through a plurality of scan lines, a data driving circuit for transferring luminance data through a plurality of data lines, and one or more pixel circuits for an Organic Light Emitting Diode (OLED) panel, the pixel circuits being connected and formed at locations where the scan lines and the data lines in a matrix form intersect, wherein each of the pixel circuits comprises a switching element driven by a scan signal input through a corresponding one of scan lines sequentially selected from among the plurality of scan lines and configured to transfer drive current based on luminance data input through a corresponding one of the data lines, and an OLED configured to emit light using the drive current transferred by the switching element.

In accordance with a further aspect of the present invention to accomplish the objects, there is provided a method of driving an Organic Light Emitting Diode (OLED) panel using pixel circuits respectively including transistors for selectively driving pixels, comprising driving each transistor using a scan signal input through a corresponding one of scan lines sequentially selected from among a plurality of scan lines, the transistor transferring drive current based on luminance data, input through a corresponding one of a plurality of data lines, to an OLED, and the OLED emitting light using the drive current.

Preferably, at the driving each transistor using the scan signal input through the corresponding one of scan lines sequentially selected from among the plurality of scan lines, the scan signal may be input through a gate terminal of the transistor.

Preferably, at the transistor transferring the drive current based on the luminance data, input through the corresponding one of the plurality of data lines, to the OLED, the drive current may be input through a drain terminal of the transistor, and the transistor may transfer the drive current to the OLED through a source terminal thereof.

Preferably, at the OLED emitting light using the drive current, the OLED may have an anode connected to the source terminal of the transistor and a cathode connected to a transparent common electrode, so that the drive current transferred through the anode is applied to the transparent common electrode connected to the cathode.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a circuit diagram showing a pixel circuit for a conventional PMOLED panel;
FIG. 2 is a circuit diagram showing a pixel circuit for a conventional AMOLED panel;
FIG. 3 is a circuit diagram showing a pixel circuit for an OLED panel according to the present invention;
FIG. 4 is a block diagram showing a display device having the pixel circuit for the OLED panel according to the present invention;
FIG. 5 is a flowchart showing a method of driving the OLED panel according to the present invention;
FIG. 6 is a sectional view of an OLED included in the pixel circuit for the OLED panel according to the present invention;
FIG. 7 is a graph showing transmittance depending on the transparent layer of the OLED;
FIG. 8 is a graph showing luminance depending on the transparent layer of the OLED;
FIG. 9 is a graph showing transmittance when the transparent layer of the OLED is made of an oxide, a salt or a mixture thereof; and
FIG. 10 is a flowchart showing a method of manufacturing the OLED included in the pixel circuit for the OLED panel according to the present invention.

### DESCRIPTION OF THE PREFERRED EMBODIMENTS

Reference now should be made to the drawings, in which the same reference numerals are used throughout the different drawings to designate the same or similar components. Further, in the description of the present invention, if detailed descriptions of related well-known constructions or functions are determined to make the gist ofthe present invention unclear, the detailed descriptions will be omitted.

Hereinafter, predetermined embodiments of the present invention will be described in detail with reference to the attached drawings.

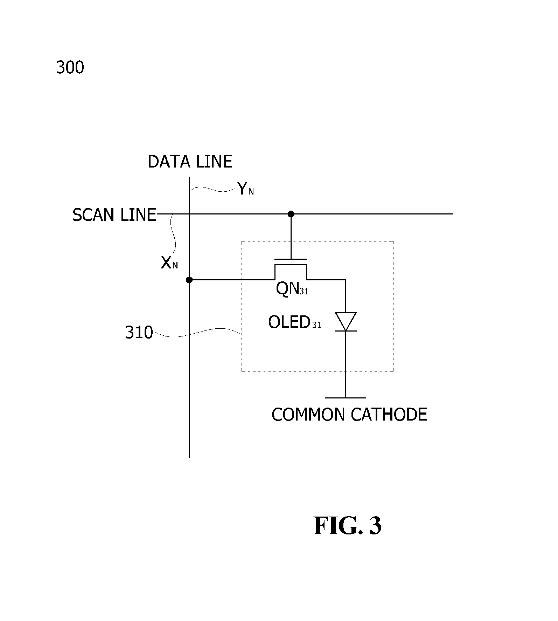

FIG. 3 is a circuit diagram showing a pixel circuit for an OLED panel according to the present invention.

Referring to FIG. 3, an OLED panel 300 according to the present invention may include a plurality of pixels present in dot matrix form. Such a dot matrix form is suitable for a relatively large display device. In FIG. 3, only one pixel of the dot matrix form-OLED panel 300 is exemplarily shown. Meanwhile, a pixel circuit 310 provided in each pixel may include a transistor QN₃₁ and an organic light emitting diode OLED₃₁. Hereinafter, the structure and operation ofthe OLED panel 300 will be described in detail.

First, the structure ofthe pixel circuit 310 of the OLED panel 300 is described as follows.

The gate terminal of the transistor QN₃₁ is connected to a scan line X_{N}, and the drain terminal thereof is connected to a data line Y_{N}. In this case, a scan signal is applied through the scan line, and luminance data indicative of luminance is applied through the data line. Further, the source terminal of the transistor QN₃₁ is connected to the OLED₃₁.

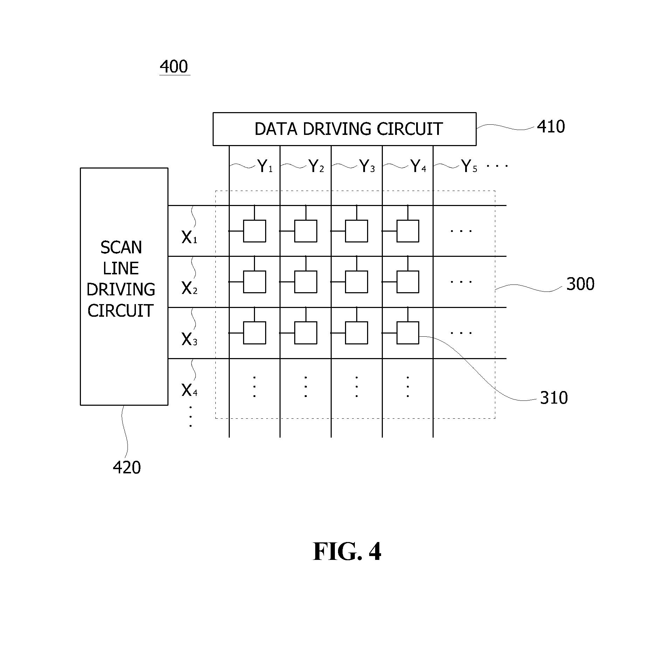

The scan signal can be input from a scan line driving circuit 420 (refer to FIG. 4), and luminance data which is the data signal can be input from a data driving circuit 410 (refer to FIG. 4). Here, the scan signal is input from the scan line driving circuit 420 through a corresponding one of scan lines sequentially selected from among a plurality of scan lines.

The data driving circuit 410 and the scan line driving circuit 420 may be implemented in the same manner as the data driving circuit (refer to the description of FIG. 1) and the scan line driving circuit (refer to the description of FIG. 1) which are used in a PMOLED panel without change.

In this case, the OLED panel 300 can be manufactured to be transparent. A transparent OLED (TOLED) panel (hereinafter indicated by reference numeral "300") is preferably implemented such that the transistor QN₃₁ is a Metal Oxide Thin Film Transistor (MOTFT). This is due to the fact that the MOTFT may be manufactured to be transparent. Of course, the MOTFT may be made of various materials. For example, an active layer may be made of Zinc Oxide (ZnO), Indium Zinc Oxide (IZnO) or Indium Gallium Zinc Oxide (IGZO).

Here, a cathode may be implemented as a transparent electrode. Since the cathode is used as a common electrode in the OLED panel 300 of the present invention, unlike in the conventional PMOLED panel 100, the problem of high resistance or the deterioration of transparency does not occur.

As described above, although being a PMOLED panel, the OLED panel 300 of the present invention uses a cathode common electrode. Further, since current flows from the data line to the cathode common electrode, the problem of the deterioration of luminance attributable to the high resistance of the scan line does not occur.

Meanwhile, the OLED panel 300 of the present invention is **characterized in that** the scan line driving circuit based on a sequential driving method and the data driving circuit, which are used in the conventional PMOLED panel, can be used without change.

Next, the operation ofthe pixel circuit 310 will be described in detail below.

First, luminance data is applied to the pixel circuit 310 through the data line connected to the transistor QN₃₁. The luminance data may include different currents obtained by dividing luminance into various levels.

Meanwhile, a relevant scan signal is applied from the scan line to the pixel circuit 310 through the gate terminal of the transistor QN₃₁. Here, scan signals are sequentially applied through respective scan lines.

Accordingly, when a relevant scan signal is applied to the gate terminal of the transistor QN₃₁ of each pixel circuit 310 through each scan line in the state in which predetermined luminance data is applied to the data line, the transistor QN₃₁ is turned on.

Luminance data current is transferred through the turned- on transistor QN₃₁. Such current flows through OLED₃, and then OLED₃₁ emits light.

As described above, the transistor QN₃₁ functions as a switching element only for OLED₃₁. This means that when the transistor QN₃₁ is turned on, the voltage thereof exceeds a transistor saturation voltage, and then the transistor QN₃₁ acts as a current path.

In the conventional AMOLED panel, since current is generated by a driving transistor to drive an OLED, the conventional AMOLED panel has limitations in performance depending on variations in characteristics such as reliability against the threshold voltage of the transistor itself. However, in the OLED panel 300 of the present invention, since the transistor QN₃₁ functions only as a switching element, variations in or deterioration of performance do not occur as long as the transistor is driven as the switching element. Accordingly, complicated construction caused by a compensation circuit technique for AMOLED or the like is not required.

Meanwhile, in the conventional PMOLED panel, since a current signal is applied through the data lines or the scan lines, the driving of the panel may be restricted due to the resistance. In contrast, in the OLED panel 300 ofthe present invention, the scan line current path of the PMOLED panel is eliminated by the transistor QN₃₁, and the cathode is used as a common ground electrode, and thus restrictions attributable to resistance can be overcome.

FIG. 4 is a block diagram showing a display device having the pixel circuit for the OLED panel according to the present invention.

Referring to FIG. 4, a display device 400 having the OLED panel 300 according to the present invention may include the OLED panel 300, a data driving circuit 410, and a scan line driving circuit 420. The components ofthe display device will be described below.

First, the data driving circuit 410 provides luminance data through a plurality of data lines. That is, currents obtained by dividing luminance into various levels are provided through the data lines.

Further, the scan line driving circuit 420 sequentially outputs scan signals through a plurality of scan lines. The scan line driving circuit 420 may use the scan line driving method used by the conventional PMOLED panel without change.

In this case, an inverter circuit may be additionally inserted into the output stage of the conventional scan line driving circuit. The inverter circuit is a component for inverting the scan signals output through the scan line driving circuit 420. When the transistor QN₃₁ used in the OLED panel 300 according to the present invention is manufactured as an N-type transistor, scan lines based on the conventional PMOLED driving method form P-type negative voltages, and thus an additional component such as the inverter circuit is required. From the standpoint of the manufacture of an IC chip, such an inverter may be manufactured to be embedded in a circuit and may be selectively used depending on whether an N-type or P-type transistor QN₃₁ has been selected.

Further, the OLED panel 300 includes a plurality of pixels configured in a dot matrix form, each pixel including the pixel circuit 310 according to the present invention.

The pixel circuit 310 may be connected and formed at each of the locations where the scan lines and the data lines of the matrix intersect, and may include a transistor QN₃₁ and an organic light emitting diode OLED₃₁.

The transistor QN₃₁ ofthe pixel circuit 310 is driven by a scan signal input through a corresponding one of the scan lines sequentially selected from among the plurality of scan lines, and outputs drive current according to the luminance data input through a corresponding one of the data lines.

Meanwhile, the OLED₃₁ of the pixel circuit 310 emits light using the drive current transferred from the transistor QN₃₁.

The detailed operations of the transistor QN₃₁ and OLED₃₁ are identical to those described above with reference to FIG. 3.

The above-described OLED panel 300 and the display device 400 having the OLED panel 300 can be manufactured using a typical circuit manufacturing process. Each of the transistors used in the OLED panel 300 and the display device 400 may be manufactured to have a bottom gate Thin Film Transistor (TFT) structure or a top gate TFT structure.

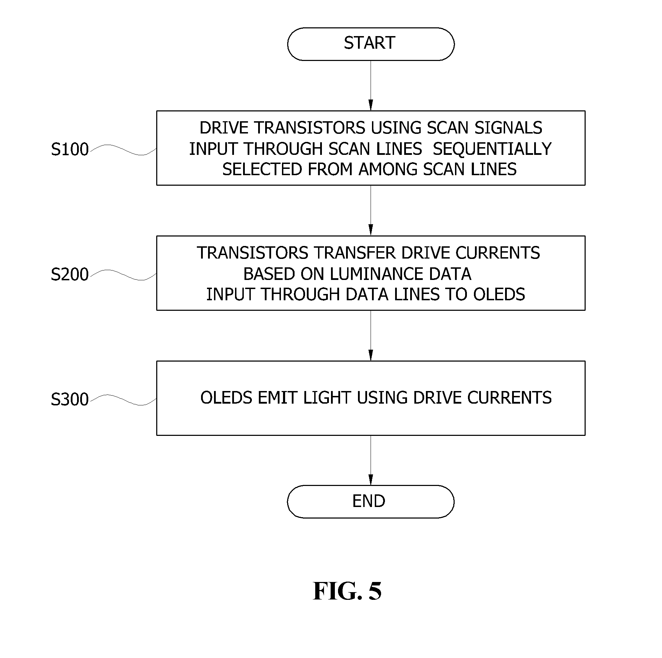

FIG. 5 is a flowchart showing a method of driving the OLED panel according to the present invention.

Referring to FIG. 5, the method of driving the OLED panel according to the present invention is performed such that in the pixel circuits 310 respectively including transistors QN₃₁ for selectively driving pixels, each transistor QN₃₁ is driven by a scan signal input through a corresponding one of scan lines sequentially selected from among a plurality of scan lines at step S100. In this case, the scan signal may be input through the gate terminal of the transistor QN₃₁.

Next, the transistor QN₃₁ transfers drive current based on luminance data, input through a corresponding one of data lines, to OLED₃₁ at step S200. Here, the drive current may be input to a corresponding pixel circuit 310 through the drain terminal of the transistor QN₃₁ and may be transferred to OLED₃₁ through the source terminal of the transistor QN₃₁.

Next, OLED₃₁ emits light using the drive current transferred through the source terminal of the transistor QN₃₁ at step S300. In this case, the anode of OLED₃₁ may be connected to the source terminal of the transistor QN₃₁ and the cathode of OLED₃₁ may be connected to a transparent common electrode.

Meanwhile, the transistor QN₃₁ may be preferably an N-type or P-type Metal Oxide Thin Film Transistor (MOTFT). In this case, the MOTFT may be configured to include an active layer made of any one selected from the group consisting of Zinc Oxide (ZnO), Indium Zinc Oxide (IZnO) and Indium Gallium Zinc Oxide (IGZO).

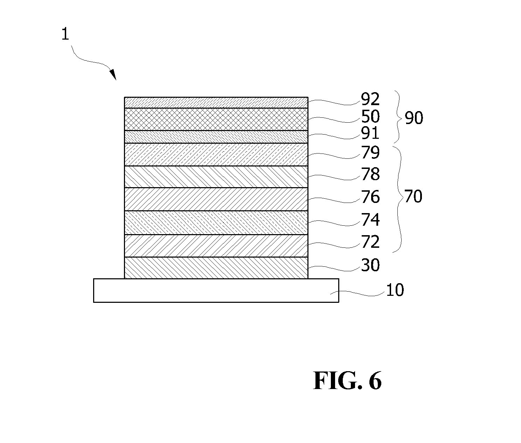

FIG. 6 is a sectional view showing the OLED included in the pixel circuit for the OLED panel according to the present invention.

As shown in FIG. 6, an OLED₃₁ 1 according to the present invention includes a substrate 10, a first electrode 30, a second electrode 50, an organic layer 70, and a transparent layer 90.

The substrate 10 supports the first electrode 30, the second electrode 50, the organic layer 70, and the transparent layer 90. The substrate 10 is made of glass or plastic material which has transparency so that emitted light can pass through the substrate 10.

The first electrode 30 is commonly referred to as a lower electrode and formed on the substrate 10. The first electrode 30 is an anode, that is, a positive (+) electrode, and is formed on the substrate 10 using any one of a sputtering method, an ion plating method, and a thermal evaporation method using an electron (e) gun. Here, although an indium-tin oxide electrode having transparency is used as the first electrode 30 according to the embodiment of the present invention, an indium-zinc oxide electrode having transparency may be used.

The second electrode 50, which is opposite to the first electrode 30, is commonly referred to as an upper electrode, and is formed on the organic layer 70. The second electrode 50 is a cathode, that is, a negative (-) electrode, which is the opposite of the first electrode 30, that is, the positive electrode. The second electrode 50 is made of any one selected from the group consisting of silver (Ag), aluminum (Al), and a magnesium-silver (Mg-Ag) alloy having transparency.

The organic layer 70 is interposed between the first electrode 30 and the second electrode 50, and emits light by the electrical conduction between the first electrode 30 and the second electrode 50. The organic layer 70 includes a Hole Injection Layer (HIL) 72, a Hole Transporting Layer (HTL) 74, an EMissive Layer (EML) 76, an Electron Transporting Layer (ETL) 78, and an Electron Injection Layer (EIL) 79 so that the organic layer 70 can emit light using the electrical conduction between the first electrode 30 and the second electrode 50.

Here, the organic layer 70 is interposed between the first electrode 30 and the second electrode 50 using one of a spin coating method, a thermal evaporation method, a spin casting method, a sputtering method, an electron (e)-beam evaporation method, and a Chemical Vapor Deposition) (CVD) method.

The hole injection layer 72 functions to enable holes to be injected from the first electrode 30, and the hole transporting layer 74 functions as the movement path of the holes injected from the hole injection layer 72 so that the injected holes can meet the electrons from the second electrode 50.

The electron injection layer 79 functions to enable electrons to be injected from the second electrode 50, and the electron transporting layer 78 functions as the movement path of electrons injected from the electron injection layer 79 so that the electrons meet the holes, moving from the hole transporting layer 74, in the emissive layer 76.

In order to facilitate the injection of the electrons from the second electrode 50, the electron transporting layer 78 can be doped with any one selected from the group consisting of low-work-function metals and mixtures thereof, which can be applied regardless of the existence of the electron injection layer 79.

Here, the low-work-function metals may include Cs, Li, Na, K, and Ca, and the mixtures thereof may include Li-Al, LiF, CsF, and Cs₂CO₃.

Meanwhile, the emissive layer 76 is interposed between the hole transporting layer 74 and the electron transporting layer 78, and emits light using the holes from the hole transporting layer 74 and the electrons from the electron transporting layer 78. That is, the emissive layer 76 emits light by the holes and electrons which meet on the boundary surface between the hole transporting layer 74 and the electron transporting layer 78.

The transparent layer 90 may be formed between the organic layer 70 and the second electrode 50 and/or on the second electrode 50. For example, the transparent layer 90 may be formed on both the top surface and bottom surface of the second electrode 50, or on the top or bottom surface of the second electrode 50.

Although this embodiment shows an example of a configuration in which the transparent layer 90 is formed on both the top and bottom surfaces ofthe second electrode 50, the present invention is not limited thereto, but a configuration in which the transparent layer 90 is formed on only the top or bottom surface of the second electrode 50 may be applied to the present invention.

The transparent layer 90 may include a first transparent layer 91 formed between the organic layer 70 and the second electrode 50 and a second transparent layer 92 formed on the top surface of the second electrode 50.

Preferably, the first transparent layer 91 may be formed between the electron injection layer 79 and second electrode 50 of the organic layer 70, and may be formed in the electron injection layer 79 itself. Further, the second transparent layer 92 may be placed on the top surface of the second electrode 50 which faces the first transparent layer 91.

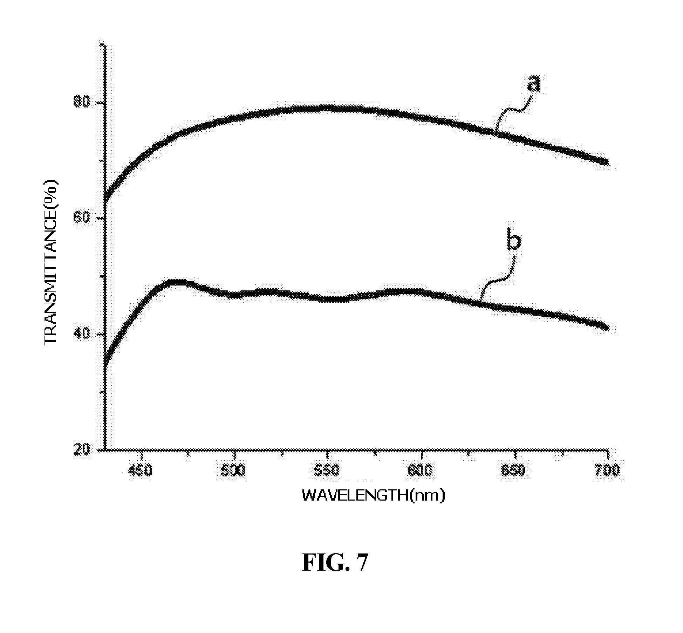

Here, the transparent layer 90 functions to enable the second electrode 50 to have both transparency and high transmittance. Further, the transparent layer 90 is configured in the form of a thin film, and thus reduces the surface resistance of the second electrode 50, thereby preventing the performance of the TOLED panel from being deteriorated. The characteristics of the transparent layer 90 will be described with reference to FIGS. 7 to 9 after oxides, nitrides, salts, and mixtures thereof have been described.

The transparent layer 90 according to the present invention may include any one selected from the group consisting of oxides, nitrides, salts and mixtures thereof.

In this case, the oxides may include MoO₃, ITO, IZO, IO, ZnO, TO, TiO₂, SiO₂, WO₃, Al₂O₃, Cr₂O₃, TeO₂, and SrO₂. The nitrides may include SiN and AIN. Further, the salts may include Cs₂CO₃, LiCO₃, KCO₃, NaCO₃, LiF, CsF, and ZnSe.

Although it is preferable to use the oxide, the nitride, the salt or the mixture included in the transparent layer 90 because excellent transmittance and luminance can be exhibited, as shown in FIGS. 7 to 9, any material, other than those materials, may be included in the transparent layer 90 as long as the material enables the second electrode 50 to have both transparency and high transmittance.

Although the first transparent layer 91 and the second transparent layer 92 of the transparent layer 90 are made of the same material, they may be made of different materials. For example, the first transparent layer 91 may include an oxide, and the second transparent layer 92 may include a nitride, a salt or a mixture thereof Alternatively, the first transparent layer 91 may include a nitride, and the second transparent layer 92 may include an oxide, a salt or a mixture thereof Alternatively, the first transparent layer 91 may include a salt, and the second transparent layer 92 may include an oxide, a nitride or a mixture thereof.

It is preferred that the thickness of the transparent layer 90 be equal to or greater than 0.1 nm and less than 100 nm. The reason for limiting the thickness ofthe transparent layer 90 is, for example, that when the thickness of the transparent layer 90 is less than 0.1 nm, transmittance increases, and resistance also increases in proportion thereto, and thus the performance of the TOLED panel 300 is deteriorated.

In contrast, when the thickness of the transparent layer 90 is equal to or greater than 100 nm, the performance is not deteriorated due to decrease in resistance, but the transmittance decreases due to increase in the thickness of the transparent layer 90. Meanwhile, it is preferred that the transparent layer 90 according to the embodiment of the present invention be preferably formed using thermal evaporation.

Referring to FIGS. 7 to 9, the characteristics of the OLED having the above-described configuration according to the present invention will be described in relation to the above construction.

FIG. 7 is a graph showing transmittance depending on whether the transparent layer 90 is present in the OLED 1 according to the present invention. In FIG. 7, 'a' denotes a curve for the OLED 1 with the transparent layer 90 according to the present invention, and 'b' denotes a curve for an OLED without the transparent layer 90, which is different from that of the present invention.

The OLED 1 according to the present invention may exhibit a transmittance ranging from 70 to 99% depending on the wavelength (nm). For example, as shown in FIG. 7, with regard to the transmittance depending on wavelength (nm), the TOLED panel 300 according to the present invention exhibits a transmittance of about 80% at a wavelength of 550 nm, while the TOLED panel without the transparent layer 90 exhibits a transmittance of about 47%. Referring to these results, it can be seen that the transmittance of the TOLED panel 300 with the transparent layer 90 is 1.7 times as high as that of the TOLED panel without the transparent layer 90.

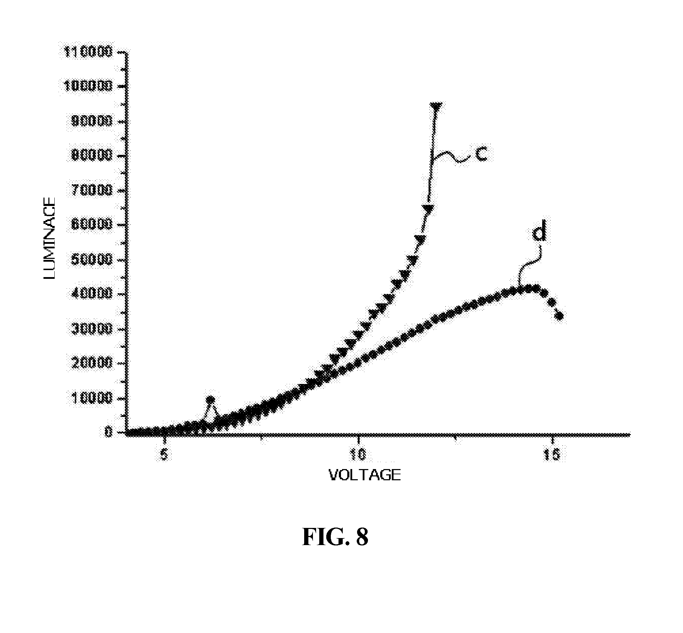

FIG. 8 is a graph showing luminance depending on whether the transparent layer 90 is present in the OLED 1. In FIG. 8, 'c' denotes a curve for the OLED 1 according to the present invention, and 'd' denotes a curve for the OLED without the transparent layer 90.

With regard to the luminance depending on a voltage of 10V, the TOLED panel 300 with the transparent layer 90 exhibits a luminance of about 25000 and a TOLED panel without the transparent layer 90 exhibits a luminance of about 20000. Accordingly, it can be seen that there is a 1.2 times difference in the luminance depending on whether the transparent layer 90 is present.

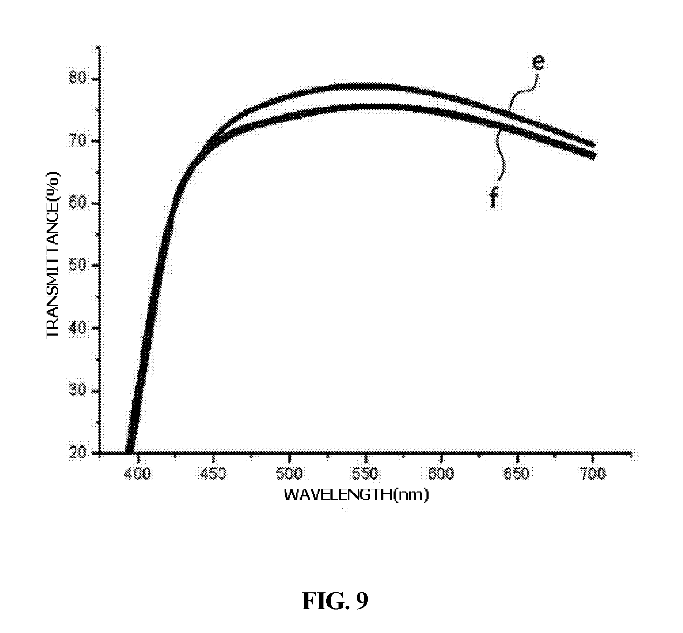

In FIG. 9, curve 'e' denotes transmittance for the transparent layer 90 made of an oxide such as MoO₃, ITO, IZO, IO, ZnO, TO, TiO₂, SiO₂, WO₃, Al₂O₃, Cr₂O₃, TeO₂ or SrO₂, and curve 'f' denotes transmittance for the transparent layer 90 made of a salt such as Cs₂CO₃, LiCO₃, KCO₃, NaCO₃, LiF, CsF, or ZnSe.

As shown in FIG. 9, a transmittance of about 80% is obtained when the transparent layer 90 is made of an oxide while a transmittance of about 75% is obtained when the transparent layer 90 is made of a salt. Although the transmittance for the transparent layer 90 made of an oxide is 5% higher than that for the transmitting layer 90 made of a salt, this is merely a small difference, so that it may be preferable to selectively use an oxide, a salt and a mixture thereof, as in the embodiment ofthe present invention.

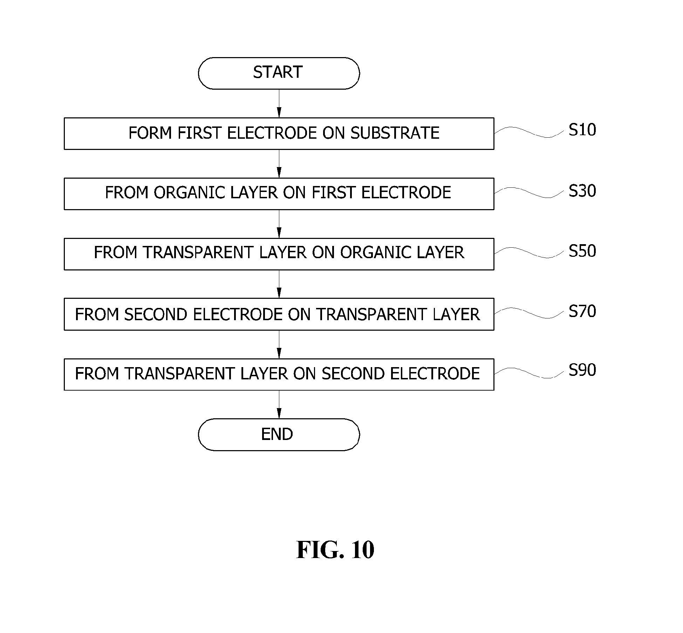

A method of manufacturing the OLED 1 according to the present invention will be described below with reference to FIG. 10.

First, the first electrode 30 which is a positive (+) electrode is formed on the substrate 10 at step S10.

After the first electrode 30 has been formed on the substrate 10, the organic layer 70 is formed on the first electrode 30 at step S30. In this case, the organic layer 70 formed on the first electrode 30 is formed in the sequence of the hole injection layer 72, the hole transporting layer 74, the emissive layer 76, the electron transporting layer 78 and the electron injection layer 79.

The first transparent layer 91 is formed on the organic layer 70 at step S50. In an embodiment of the present invention, the first transparent layer 91 may include an oxide such as MoO₃, ITO, IZO, IO, ZnO, TO, TiO₂, SiO₂, WO₃, Al₂O₃, Cr₂O₃, TeO₂ or SrO₂. The thickness of the first transparent layer 91 is equal to or greater than 0.1 nm and less than 100 nm, in consideration of resistance and transmittance.

Thereafter, the second electrode 50 is formed on the first transparent layer 91 at step S70. The second electrode 50 is a negative (-) electrode and is formed of a thin metal film. The thin metal film used as the second electrode 50 is made of any one of Ag, Al and an Mg-Ag alloy.

The second transparent layer 92 is formed on the second electrode 50 at step S90. The second transparent layer 92 may include an oxide as at step S50. However, the second transparent layer 92 formed on the second electrode 50 may include any one selected from the group consisting of nitrides such as SiN and AIN, salts such as Cs₂CO₃, LiCO₃, KCO₃, NaCO₃, LiF, CsF and ZnSe, and mixtures thereof

Accordingly, the transparent layer 90 is formed with the second electrode 50 disposed therein, so that double-sided light emission can be implemented and the transmittance can be improved.

Further, the transparent layer 90 may be formed to adjust the thickness of the second electrode 50, thereby improving transmittance and electrical performance.

As described above, the present invention is advantageous in that transistors functioning to perform switching are provided in the structure of a conventional PMOLED panel, thus solving problems such as the imbalance of luminance attributable to the sequential driving of scan lines and the complexity of circuits occurring in the structure of a conventional AMOLED panel.

Further, the TOLED panel is implemented by forming the transparent layer including any one selected from the group consisting of oxides, nitrides, salts and mixtures thereof, between the organic layer and the second electrode (cathode electrode) and/or on the second electrode, thus enabling TOLEDs capable of realizing double-sided light emission to be implemented and improving transmittance.

Furthermore, the transparent layer is made of any one selected from the group consisting of oxides, nitrides, salts and mixtures thereof, so that the increase in the internal resistance of the second electrode can be prevented, thus improving the electrical performance of products.

The advantages of the present invention are not limited to the above-described advantages, and those skilled in the art will clearly understand other advantages which are not described here from a description of the accompanying claims.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

### Industrial Applicability

The present invention can be used for producing a display device having a pixel circuit for an OLED panel, which does not cause the problem of the imbalance of luminance while simplifying the structure of the OLED panel compared to an AMOLED panel.

## Claims

1. A pixel circuit for an Organic Light Emitting Diode (OLED) panel, comprising:
a switching element driven by a scan signal input through a corresponding one of scan lines sequentially selected from among a plurality of scan lines, and configured to transfer drive current based on luminance data input through a corresponding one of a plurality of data lines; and
an OLED configured to emit light using the drive current transferred by the switching element.

2. The pixel circuit according to claim 1, wherein the switching element comprises a transistor, a gate terminal of which is connected to the corresponding scan line, a drain terminal of which is connected to the corresponding data line, and a source terminal of which is connected to the OLED.

3. The pixel circuit according to claim 2, wherein the OLED has an anode connected to the source terminal of the transistor and a cathode connected to a common electrode.

4. The pixel circuit according to claim 2, wherein the transistor is an N-type or P-type metal oxide thin film transistor.

5. The pixel circuit according to claim 4, wherein the metal oxide thin film transistor comprises an active layer made of any one selected from a group consisting of Zinc Oxide (ZnO), Indium Zinc Oxide (IZnO) and Indium Gallium Zinc Oxide (IGZO).

6. The pixel circuit according to claim 1, wherein the OLED comprises a transparent OLED (TOLED).

7. The pixel circuit according to claim 1, wherein the OLED comprises:
a substrate;
a first electrode formed on the substrate;
an organic layer formed on the first electrode;
a second electrode formed on the organic layer; and
a transparent layer formed between the organic layer and the second electrode and/or on the second electrode, and configured to include any one selected from a group consisting of oxides, nitrides, salts and mixtures thereof.

8. The pixel circuit according to claim 7, wherein the oxides comprise any one selected from a group consisting of MoO₃, ITO, IZO, IO, ZnO, TO, TiO₂, SiO₂, WO₃, Al₂O₃, Cr₂O₃, TeO₂, and SrO₂.

9. The pixel circuit according to claim 7, wherein the nitrides comprise any one selected from a group consisting of SiN and AIN.

10. The pixel circuit according to claim 7, wherein the salts comprise any one selected from a group consisting of Cs₂CO₃, LiCO₃, KCO₃, NaCO₃, LiF, CsF and ZnSe.

11. The pixel circuit according to claim 7, wherein the transparent layer is formed to have a thickness which is equal to or greater than 0.1 nm and less than 100 nm.

12. The pixel circuit according to claim 7, wherein the organic layer comprises an electron transporting layer doped with any one selected from a group consisting of low-work-function materials and mixtures thereof to facilitate injection of electrons from the second electrode.

13. The pixel circuit according to claim 12, wherein the low-work-function metals comprise any one selected from a group consisting of Cs, Li, Na, K and Ca.

14. The pixel circuit according to claim 12, wherein the mixtures of the low-work-function metals comprise any one selected from a group consisting of Li-Al, LiF, CsF and Cs₂CO₃.

15. The pixel circuit according to claim 7, wherein the OLED exhibits a transmittance ranging from 70 to 99% depending on wavelength (nm).

16. A display device, comprising:
a scan line driving circuit for sequentially outputting scan signals through a plurality of scan lines;
a data driving circuit for transferring luminance data through a plurality of data lines; and
one or more pixel circuits for an Organic Light Emitting Diode (OLED) panel, the pixel circuits being connected and formed at locations where the scan lines and the data lines in a matrix form intersect, wherein each of the pixel circuits comprises a switching element driven by a scan signal input through a corresponding one of scan lines sequentially selected from among the plurality of scan lines and configured to transfer drive current based on luminance data input through a corresponding one of the data lines, and an OLED configured to emit light using the drive current transferred by the switching element.

17. The display device according to claim 16, wherein the switching element comprises a transistor, a gate terminal of which is connected to the corresponding scan line, a drain terminal of which is connected to the corresponding data line, and a source terminal of which is connected to the OLED.

18. The display device according to claim 17, wherein the OLED has an anode connected to the source terminal of the transistor and a cathode connected to a common electrode.

19. The display device according to claim 17, wherein the transistor is an N-type or P-type metal oxide thin film transistor.

20. The display device according to claim 16, wherein the OLED comprises a Transparent OLED (TOLED).

21. A method of driving an Organic Light Emitting Diode (OLED) panel using pixel circuits respectively including transistors for selectively driving pixels, comprising:
driving each transistor using a scan signal input through a corresponding one of scan lines sequentially selected from among a plurality of scan lines;
the transistor transferring drive current based on luminance data, input through a corresponding one of a plurality of data lines, to an OLED; and
the OLED emitting light using the drive current.

22. The method according to claim 21, wherein at the driving each transistor using the scan signal input through the corresponding one of scan lines sequentially selected from among the plurality of scan lines, the scan signal is input through a gate terminal of the transistor.

23. The method according to claim 22, wherein at the transistor transferring the drive current based on the luminance data, input through the corresponding one of the plurality of data lines, to the OLED, the drive current is input through a drain terminal of the transistor, and the transistor transfers the drive current to the OLED through a source terminal thereof.

24. The method according to claim 23, wherein at the OLED emitting light using the drive current, the OLED has an anode connected to the source terminal of the transistor and a cathode connected to a transparent common electrode, so that the drive current transferred through the anode is applied to the transparent common electrode connected to the cathode.
